# EUROPEAN PATENT APPLICATION

(11) **EP 3 457 549 A1**
(43) Date of publication of application: **20.03.2019**
(21) Application number: 18192531.4
(22) Date of filing: 04.09.2018
(51) Int. Cl.: H02M 1/088, H02M 1/32

(54) **METHOD AND SYSTEM FOR CONTROLLING VOLTAGE BALANCE OF A SERIALIZED POWER SWITCHING DEVICE**

(30) Priority: 18.09.2017 CN 201710840594
(71) Applicant: General Electric Company, Schenectady, NY 12345 (US)
(72) Inventor: QU, Bo, Shanghai, Shanghai 201203 (CN); ZHANG, Ying, ShangHai, Shanghai 201203 (CN); MECHLINSKI, Marius Michael, 85748 Garching (DE); MAO, Saijun, Shanghai, Shanghai 201203 (CN); SHI, Jingkui, Shanghai, Shanghai 201203 (CN); XU, He, Shanghai, Shanghai 201203 (CN); YUAN, Zhihui, Niskayuna, NY 12309 (US); SHEN, Jie, Niskayuna, NY 12309 (US); SCHROEDER, Stefan, Niskayuna, NY 12309 (US)
(74) Representative: Fischer, Michael Maria

(57) **Abstract**

The present disclosure relates to a method for controlling voltage balance of a serialized power switching device, comprising generating a reference voltage based on actual individual voltage of each switch of the serialized power switching device or setting a reference voltage based on supplied voltage to the serialized power switching device; determining an individual blocking voltage mismatch of at least one switch when existing a difference between the reference voltage and the actual individual voltage of at least one switch, wherein the individual voltage mismatch is based on the difference between the reference voltage and the actual individual voltage; calculating an individual delay mismatch for the at least one switch; and compensating the individual delay mismatch for the at least one switch. The present disclosure also relates to a system for controlling voltage balance of a serialized power switching device. The present disclosure also relates to a power switching device.

## Description

### BACKGROUND

Embodiments of the disclosure relate generally to systems and methods of controlling voltage balance among series-connected switching devices.

In high voltage applications, serialization with low voltage devices instead of using high voltage devices is a good solution for low cost. However, voltage balance of each serialized power semiconductor device is a big problem. Such voltage unbalance among serialized devices may cause some devices holding much higher voltage than the others and may greatly increase the failure rate of devices. The voltage unbalance is mainly caused by propagation delay mismatch of gating signals and the performance variation among serialized devices. These factors may also vary with component manufacturing, temperature, aging etc. To attenuate the effect, snubber circuits providing with several snubber components are commonly used to balance the voltage of serialized devices. However, such snubber circuits increase the circuit complexity, power loss and cost, as well as decrease the system reliability which would causes more effort for factory manufacturing.

Therefore, it would be desirable if a system and a method could be provided to achieve a voltage balancing for a serialized power switching device at least with low cost, simple configuration and high reliability.

### BRIEF DESCRIPTION

In accordance with one embodiment disclosed herein, a method for controlling voltage balance of a serialized power switching device is provided. The method comprises generating a reference voltage based on actual individual voltage of each switch of the serialized power switching device or setting a reference voltage based on supplied voltage to the serialized power switching device; determining an individual voltage mismatch of at least one switch when existing a difference between the reference voltage and the actual individual voltage of at least one switch, wherein the individual voltage mismatch is based on the difference between the reference voltage and the actual individual voltage; calculating an individual delay mismatch for the at least one switch; and compensating the individual delay mismatch for the at least one switch.

In accordance with another embodiment disclosed herein, a system for controlling voltage balance of a serialized power switching device is provided. The system comprises a regulator for generating a reference voltage based on actual individual voltage of each switch of the serialized power switching device or for setting a reference voltage based on supplied voltage to the serialized power switching device; a calculator configured for determining an individual voltage mismatch of at least one switch when existing a difference between the reference voltage and the actual individual voltage of at least one switch, wherein the individual voltage mismatch is based on the difference between the reference voltage and the actual individual voltage; an adjustor configured for calculating an individual delay mismatch for at least one switch; and a compensator configured for compensating the individual delay mismatch for at least one switch.

In accordance with another embodiment disclosed herein, a power switching assembly is provided. The power switching assembly comprises a serialized power switching device comprising at least two series-connected switches; and a system as above mentioned, electrically coupled to the serialized power switching device, for controlling voltage balance of the serialized power switching device.

### DRAWINGS

These and other features and aspects of the present disclosure will become better understood when the following detailed description is read with reference to the accompanying drawings in which like characters represent like parts throughout the drawings, wherein:
FIG. 1 is a schematic diagram of a power switching assembly according to one embodiment; and
FIG. 2 is a flow diagram of a process for controlling a voltage balance of a serialized power switching device according to one embodiment.

### DETAILED DESCRIPTION

Unless defined otherwise, technical and scientific terms used herein have the same meaning as is commonly understood by one of ordinary skill in the art to which this disclosure belongs. The terms "a" and "an" do not denote a limitation of quantity, but rather denote the presence of at least one of the referenced items. The use of "including," "comprising" or "having" and variations thereof herein are meant to encompass the items listed thereafter and equivalents thereof as well as additional items. The terms "connected" and "coupled" are not restricted to physical or mechanical connections or couplings, and can include electrical connections or couplings, whether direct or indirect.

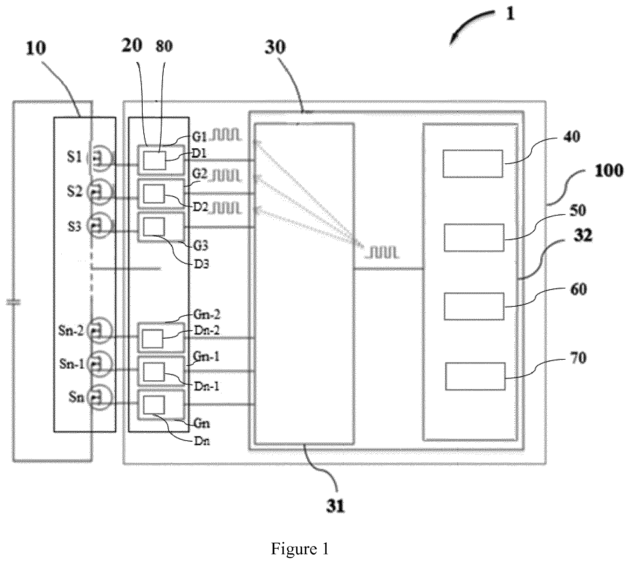

Referring to FIG. 1, a schematic diagram of a power switching assembly 1 according to one embodiment is shown. In this illustrated embodiment, the power switching assembly 1 comprises a serialized power switching device 10. The serialized power switching device 10 may include at least two series-connected switches S₁, S₂, ..., Sₙ. The switches S₁, S₂, ..., Sₙ may comprise, without limitation, Insulated Gate Bipolar Transistors (IGBT), Integrated Gate Commutated Thyristor (IGCT), Metal-Oxide-Semiconductor Field Effect Transistors (MOSFET), Injection Enhanced Gate Transistors (IEGT), SiC MOSFET, or any other controllable power switch.

In this illustrated embodiment, a system 100 is further provided for the serialized power switching device 10. The system 100 is placed across the serialized power switching device 10 which is to be protected.

In one embodiment, as shown in FIG. 1, the system 100 includes a gating driver device 20. The gating driver device 20 may include at least two gating drivers G₁, G₂, ..., Gₙ. Each gating driver G₁, G₂, ..., Gₙ of the gating driver device 20 is electrically coupled to a corresponding switch S₁, S₂, ..., Sₙ, separately. For illustration purpose, one serialized power switching devices 10 and gating driver device 20 are shown in FIG. 1, but the power semiconductor assembly 1 may include two or more than two in particular applications.

In one embodiment, as shown in FIG. 1, the system 100 further includes a controller 30 which is electrically coupled to all gating drivers 20. As an example of the controller 30, a sub controller 31 and a main controller 32 are provided by the controller 30.

In this illustrated embodiment, a detector device 80 is provided within the gating driver device 20. The detector device 80 may include at least two detectors D₁, D₂, ..., Dₙ corresponding to gating drivers G₁, G₂, ..., Gₙ for detecting actual individual voltage of each switch S₁, S₂, ..., Sₙ while the switch S₁, S₂, ..., Sₙ is in the transient states or in a process of turn-on or turn-off. For exemplary purpose, gating drivers G₁, G₂, ..., Gₙ detect actual blocking voltage of each switch S₁, S₂, ..., Sₙ during the turn-off state. Generally, blocking voltage means the voltage at turn-off of the power switching device, specifically, for MOSFETs blocking voltage is the drain-source voltage (Vds) during the turn-off state, for IGBTs blocking voltage is the collector-emitter voltage (Vce) at turn-off. Moreover, each gating driver G₁, G₂, ..., Gₙ collects information of the actual individual voltage, e.g., blocking voltage, of each switch S₁, S₂, ..., Sₙ. It could be understood that the actual individual blocking voltage of each switch S₁, S₂, ..., Sₙ may not be the same, which can be caused by the switch performance variation and the propagation delay mismatch of gating signals sent by the switch.

In one embodiment, each gating driver 20 transmits the information as collected to the sub controller 31, in which the information is used for voltage unbalance control. The sub controller 31 receives the information of the actual individual blocking voltage of all serialized switches S₁, S₂, ..., Sₙ and continues to transmit the information to the main controller 32. A regulator 40 is provided by the main controller 32 for generating a reference voltage based on the actual individual blocking voltage of all serialized switches S₁, S₂, ..., Sₙ or for setting a reference voltage based on supplied voltage to the serialized power switching device. As one example, the reference voltage may be an average value of all the actual individual blocking voltage, i.e., average voltage. As another example, the reference voltage may be equal to the supplied voltage to the serialized power switching device. A calculator 50 is further provided by the main controller 32 for calculating an individual blocking voltage mismatch between the actual individual blocking voltage and the reference voltage. An adjustor 60 is also provided by the main controller 32 for adjusting the individual blocking voltage mismatch and calculating an individual delay mismatch for the at least one switch S₁, S₂, ..., Sₙ whose actual individual blocking voltage does not equal to the reference voltage. A compensator 70 is further provided by the main controller 32 for compensating the individual delay mismatch. Specifically, the compensator 70 may have the main controller 32 send out gating signals and appropriate delay compensation value. The updated gating signals with appropriate delay compensation value will be further transmitted by the sub controller 31 and the gating driver device 20, then will be superimposed on the gating signals send by at least one switch S₁, S₂, ..., Sₙ. Thus, the blocking voltage unbalance among serialized device can be well controlled by such active compensation.

In other embodiments, the sub controller 31 may do compensation locally. As an example, the regulator 40, the calculator 50, the adjustor 60 and the compensator 70 are provided by the sub controller 31 instead of by the main controller 32. The sub controller 31 will send out gating signals with appropriate delay compensation value and have it superimposed on the gating signals send by at least one switch S₁, S₂, ..., Sₙ.

In other embodiments, the gating drivers 20 may receive the average voltage from the controller 30 or other separate device that is connected to the gating driver device 20, and do compensation locally. As an example, the regulator 40 are provided by the main controller 32; the calculator 50, the adjustor 60 and the compensator 70 are provided by the gating drivers 20. As another example, the regulator 40, the calculator 50, the adjustor 60 and the compensator 70 are provided by the gating drivers 20.

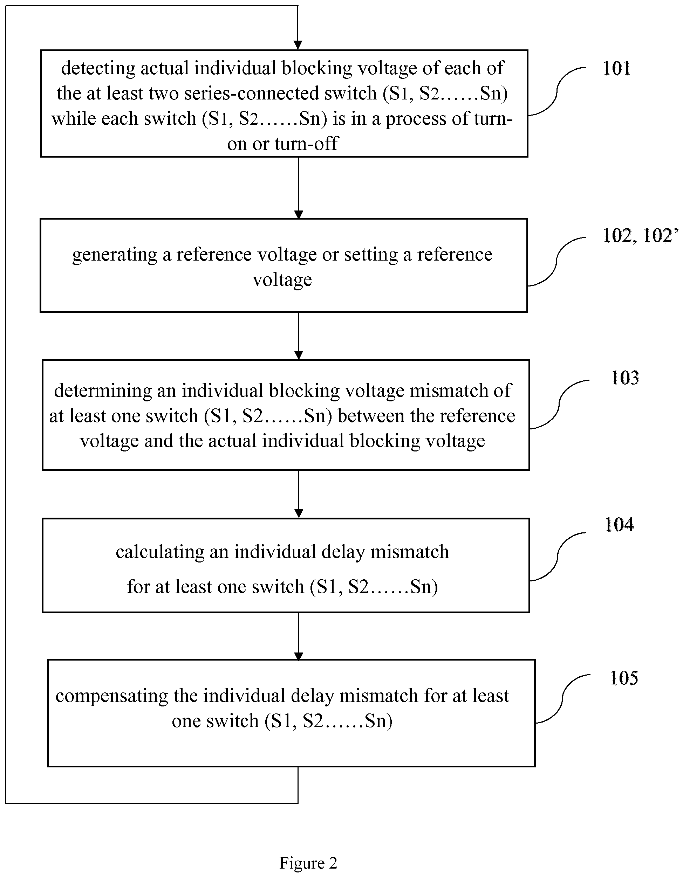

FIG. 2 is a flow diagram illustrating a process for controlling a voltage balance of a serialized power switching device in accordance with one exemplary embodiment of the present disclosure. The process may be independently implemented by the system 100 as described above.

In one embodiment, the process may include a step 101, in which actual individual blocking voltage of all series-connected switch are detected while each switch is in a process of turn-on or turn-off. As an example, the actual individual blocking voltage may be measured by gating drivers as described above with reference to FIG. 1.

In step 102, the process continues to generate a reference voltage based on all actual individual blocking voltage as detected. Alternatively, in step 102', the process continues to set a reference voltage based on supplied voltage to the serialized power switching device. In one embodiment, the reference voltage may be an average value of all the actual individual blocking voltage, i.e., average voltage. In another embodiment, the reference voltage may be equal to the supplied voltage to the serialized power switching device. As an example, the reference voltage may be defined by a controller as described above with reference to FIG. 1.

In step 103, the process continues to determine an individual blocking voltage mismatch of at least one series-connected switch between the reference voltage and the actual individual blocking voltage. As an example, the individual blocking voltage mismatch may be determined by a controller as described above with reference to FIG. 1.

In step 104, the process continues to adjust the individual blocking voltage mismatch and calculate an individual delay mismatch for at least one series-connected switch. Specifically, there is a positive correlation, e.g., approximate linear relationship, between voltage mismatch and gating signal propagation delay mismatch, the individual blocking voltage could be adjusted by additionally increasing or decreasing the gating signal delay time based on the positive correlation so that the voltage unbalance could be controlled.

In step 105, the process continues to compensate the individual delay mismatch for at least one series-connected switch. Specifically, additional gating signals with appreciated delay compensation value to have it superimposed on the gating signals sent by at least one switch so as to compensate the individual delay mismatch for at least one series-connected switch. As an example with reference to FIG. 1, a controller may generate and send out gating signals with appropriate delay compensation value, further, transmit it to gating drivers, then, have it superimposed on the gating signals sent by at least one series-connected switch.

As illustrated in FIG. 2, the process is applied as a closed circulation. In one embodiment, the process will return to step 101 after running step 105 periodically, e.g., every one minute, every one hour, even every one day. In another embodiment, the process will return to step 101 after running step 105 under a particular condition, e.g., the delay mismatch is not adequate enough to compensate the voltage mismatch.

The system and method as described above are provided for compensating the delay mismatch according to blocking voltage feedback of each series-connected switch. Besides propagation delay mismatch which is obviously related to gating time, device variation which also causes voltage unbalance can be considered as an equivalent delay mismatch between switches and can also be compensated by adjusting gating delays. With all blocking voltage feedbacks, the system and method as provided may calculate individual blocking voltage mismatch between blocking voltage and average voltage. Then, scaling voltage mismatch to delay mismatch and sending the delay compensation value to each gating signals. With such active compensation, the blocking voltage unbalance among series-connected switches can be well controlled. The system and method as provided help to reduce or even remove snubber circuit which is required for voltage balancing in device serialization and can achieve low cost, low loss, high reliability and low manufacturing cost. It can also enable automatic re-compensation of aging effects and reduce test effort in factory commissioning.

While the invention has been described with reference to exemplary embodiments, it will be understood by those skilled in the art that various changes may be made and equivalents may be substituted for elements thereof without departing from the scope of the invention. Furthermore, the skilled artisan will recognize the interchangeability of various features from different embodiments. Similarly, the various method steps and features described, as well as other known equivalents for each such methods and feature, can be mixed and matched by one of ordinary skill in this art to construct additional assemblies and techniques in accordance with principles of this disclosure. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A method for controlling voltage balance of a serialized power switching device (10), comprising:
generating (102) a reference voltage based on actual individual voltage of each switch (S₁, S₂, ..., Sₙ) of the serialized power switching device (10), or setting (102') a reference voltage based on supplied voltage to the serialized power switching device (10);
determining (103) an individual blocking voltage mismatch of at least one switch (S₁, S₂, ..., Sₙ) when existing a difference between the reference voltage and the actual individual voltage of at least one switch (S₁, S₂, ..., Sₙ), wherein the individual voltage mismatch is based on the difference between the reference voltage and the actual individual voltage;
calculating (104) an individual delay mismatch for the at least one switch (S₁, S₂, ..., Sₙ); and
compensating the individual delay mismatch for the at least one switch (S₁, S₂, ..., Sₙ).

2. A method of claim 1, further comprising:
detecting (101) the actual individual blocking voltage of each switch (S₁, S₂, ..., Sₙ) of the serialized power switching device (10).

3. A method of claim 1, wherein compensating the individual delay mismatch for the at least one switch (S₁, S₂, ..., Sₙ) comprising:
transmitting (105) at least one switch (S₁, S₂, ..., Sₙ) a gating signal to compensate the individual delay mismatch.

4. A system (100) for controlling voltage balance of a serialized power switching device (10), the system comprising:
a regulator (40) configured for generating a reference voltage based on actual individual voltage of each switch (S₁, S₂, ..., Sₙ) of the serialized power switching device (10), or for setting a reference voltage based on supplied voltage to the serialized power switching device (10);
a calculator (50) configured for determining an individual voltage mismatch of at least one switch (S₁, S₂, ..., Sₙ) when existing a difference between the reference voltage and the actual individual voltage of at least one switch (S₁, S₂, ..., Sₙ), wherein the individual voltage mismatch is based on the difference between the reference voltage and the actual individual voltage;
an adjustor (60) configured for calculating an individual delay mismatch for the at least one switch (S₁, S₂, ..., Sₙ); and
a compensator (70) configured for compensating an individual delay mismatch for the at least one switch (S₁, S₂, ..., Sₙ).

5. The system of claim 4, further comprising:
a detector (80) configured for detecting the actual individual voltage of each switch (S₁, S₂, ..., Sₙ) of the serialized power switching device (10).

6. The system of claim 4, wherein the compensator (70) is further configured for transmitting at least one switch (S₁, S₂, ..., Sₙ) a gating signal to compensate the individual delay mismatch.

7. A power switching assembly (1), comprising:
a serialized power switching device (10) comprising at least two series-connected switches (S₁, S₂, ..., Sₙ); and
a system (100) according to any one of claim 4 to 6, electrically coupled to the serialized power switching device (10), for controlling voltage balance of the serialized power switching device (10).

8. The power switching assembly of claim 7, wherein the system (100) comprises:
at least two gating drivers (20), separately electrically coupled to the at least two series-connected switches (S1, S2, ..., Sn) comprising the regulator (40), the calculator (50), the adjustor (60), the compensator (70) and the detector (80); and

9. The power switching assembly of claim 7, wherein the system (100) comprises:
at least two gating drivers (20), separately electrically coupled to the at least two series-connected switches (S₁, S₂, ..., Sₙ) comprising the calculator (50), the adjustor (60), the compensator (70) and the detector (80); and
a controller (30), electrically coupled to the at least two gating drivers (20), comprising the regulator (40).

10. The power switching assembly of claim 7, wherein the system (100) comprises:
at least two gating drivers (20), separately electrically coupled to the at least two series-connected switches (S₁, S₂, ..., Sₙ), comprising the detector (80); and
a controller (30), electrically coupled to the at least two gating drivers (20), comprising the regulator (40), the calculator (50), the adjustor (60) and the compensator (70).
